# EUROPEAN PATENT APPLICATION

(11) **EP 2 709 169 A1**
(43) Date of publication of application: **19.03.2014**
(21) Application number: 12184031.8
(22) Date of filing: 12.09.2012
(51) Int. Cl.: H01L 31/18, H01L 31/048, B32B 17/10, B32B 37/10

(54) **Local preheating of lay-up in front of lamination process**

(71) Applicant: 3S Swiss Solar Systems AG, 3250 Lyss (CH)
(72) Inventor: Polo, Roman, 3014 Bern (CH)
(74) Representative: Patentbüro Paul Rosenich AG

(57) **Abstract**

An improved and simplified system and method for laminating sandwiched bodies, lay-ups, and more particular for the lamination of solar modules is described which can be adapted for mass production inexpensively. The present invention is simple, cost effective, reliable, and environmentally friendly in operation.

A lay-up of the solar cell module is preheated before laminating, the preheating being a preferential using dedicated localised heating in a cross connector region of the module.

## Description

### FIELD OF THE INVENTION

The present invention relates generally to laminating of sandwiched bodies having electronic components in the sandwich such as solar cells and in particular the present invention relates to the manufacture of solar panels and to the panels themselves, as well as to the production equipment for carrying out the process of laminating sandwiched bodies such as solar panels.

### TECHNICAL BACKGROUND

Manufacture of sandwiched bodies and solar panels is known. In the lamination of lay-up of crystalline solar modules, multiple layers including encapsulating material which can be in the form of an adhesive foil are joined together under the influence of heat and pressure. During lamination, the encapsulating material undergoes physical and chemical changes. Amongst others, a polymerisation process may be initiated and gases can be set free. For this purpose an autoclave is often used in which the lay-up is subjected to pressure and temperature while the chamber is evacuated.

A lay-up for a solar module is formed before lamination using a carrier material in the production line such as e.g. a glass plate populated with the encapsulation material (e.g. ethyl vinyl acetate polymer (EVA)) on the carrier. On top of the encapsulation there is the cell matrix. The matrix consists of strings of cells interconnected with cross connectors (e.g. ribbons connecting the individual strings into one meandering string, i.e. multiple strings connected in series). On top of this composition another layer of encapsulant is placed before the final layer that finishes off the lay-up and the later module. Normally a back sheet or a second glass plate is used. Note that EVA is just one type of encapsulant. Other suitable materials are PVB (Polyvinyl butyral), or silicone for example. The back sheet is typically a foil containing PVF or a second glass plate. Other materials and layers can be used, e.g. insulation or optical layers.

The solar panel is then placed onto an insertion table, from which the lay-up is transported into the laminator. According to the state of the art, these lay-ups may be pre-heated in a first preheater. The heating unit heats up the complete solar modules to about 60°C. The temperature is selected making sure that the encapsulant does not melt thus entrapping air. This results in a reduction of the cycle time of up to 20% as compared to lamination without preheating. Moreover, fluctuations of the temperature of the incoming solar modules are thus compensated leading to a reproducible process. To heat the complete lay-ups, normally one or two heating plates are used.

The lamination of the solar modules is done in at least one vacuum chamber. During lamination, the lay-up is heated and pressed together. The solar modules may be processed in one or two subsequent heating chambers, for example.

### SUMMARY OF THE INVENTION

An object of the present invention is to overcome some of the disadvantages of known lay-up laminating systems, methods and production equipment, more particularly the existing solar module laminating methods, systems and production equipment.

An improved and simplified system and method for laminating sandwiched bodies, lay-ups, and more particular for the lamination of solar modules is described which can be adapted for mass production inexpensively. The present invention is simple, cost effective, reliable, and environmentally friendly in operation.

The present invention is based on the realisation that bubbles frequently occur around the area of cross connectors due to the bad heat transmission in the area of those cross connectors. It is assumed, without being limited by theory, that heat transmission during lamination, when the lay-up is pressed together and heat is applied from the bottom, is low in this area because the layers of the lay-up do not touch each other as well as in other areas. It is assumed that the best heat transfer is there where glass, a first layer of encapsulation material (such as EVA, PVB, TPO/polythene), a solar cell, a second layer of encapsulation material (e.g. EVA, PVB, TPO/polythene) and the back sheet lay parallel on top of each other because of the thickness of the cross connectors. Since the cross connectors are in the peripheral area of the lay-up, the heating is also not as effective. Also the cross connectors themselves form an additional mass that needs to be heated.

In one aspect of the present invention, an apparatus for preheating a lay-up of a solar cell module ready for lamination, the apparatus comprising: a preheater for preheating the lay-up of the module, the preheater being a dedicated localised heating means for locally preheating the lay-up in a cross-connector region of the lay-up.

The term locally means that other regions of the lay-up are kept at a temperature which can be the temperature the materials normally have, e.g. normally at room temperature. The local preheating may cause the temperature of other regions of the lay-up to rise in temperature. This global rise will generally be much less than in the cross-connector region, e.g. by a couple of degrees. The heat source is aimed at heating defined regions, independent of what happens to other regions. Hence the local heating is preferentially or mainly in the region of the cross-connectors or the borders but not necessarily exclusively so. Moreover, the main difference is that no complete or even homogenous heating is aimed for.

By mainly, preferentially or only heating the lay-up locally, the costs for the equipment can be reduced drastically: no homogenous heating (which is a difficult task for such large areas) for the entire module is needed at the preheating stage. Also the construction can become lighter, thus saving material and thus costs. Also energy is saved because not all material is heated, inescapably losing warmth before entering the laminator.

The lay-up of the solar cell module can be assembled in a heating unit or assembled separately and moved to the heating unit.

The preheater may heat by radiation. Radiation is preferably used so that heat penetrates into the inner surfaces and components of the module.

Means for removing the preheated module from the heating unit can also be provided, e.g. in the form of a conveyor. Alternatively the preheater may be located in the laminator.

The dedicated localised heating means can be selected from the group heating tubes, lamps, heating plates, heating coils, radiators. Preferably the preheaters can be switched on and switched off quickly (e.g. lamps) so that heating times are shorter and the operation can be controlled easily.

The dedicated localised heating means can be located above the lay-up and applies heat from above (e.g. radiates downwards) or can be located below the lay-up and applies heat from below, e.g. radiates upwards.

The apparatus further comprises a support for supporting or conveying the lay-up and the dedicated localised heating means can be located in the support.

The heating unit can be used with a laminator. In a further embodiment, the laminator can have at least one vacuum chamber and the preheater can be integrated in the at least one vacuum chamber.

The present invention also provides a method for preheating a lay-up for a solar cell module ready for laminating, the method comprising the steps of
preheating a lay-up of the solar cell module, the preheating being a preferential and dedicated localised heating in a cross connector region of the module.

The preheating preferably heats the lay-up to 30 to 90°C e.g. depending upon the materials used in the lay-up.

The lay-up of the solar cell module may be assembled in the heating unit or may be assembled elsewhere and moved to the heating unit.

The method can comprise removing the preheated module from the heating unit, and introducing the preheated module into a laminator. Alternatively the preheating may be done in the laminator.

The preheating step is preferably performed by dedicated localised heating means selected from the group heating tubes, lamps, heating coils, heating plates, radiators.

The operation of the preheating step and a laminating step is preferably synchronised to reduce energy consumption.

In a following step the lay-up can be heated and pressed together in a laminator.

The present invention in another aspect provides a laminator with at least one vacuum chamber, where the preheater for preheating the lay-up of the module is integrated in the at least one vacuum chamber.

The preheater is preferably a dedicated localised heating means for locally preheating the lay-up in a cross-connector region of the lay-up.

The preheater can be integrated in a heating plate with preheating of the lay-up from below, in a membrane with preheating from above or in a heating plate that presses on the lay-up during lamination with preheating from above.

Ideally the operation of the preheating step and a laminating step is synchronized to reduce energy consumption. Moreover the local preheating is done such that the lay-up can be introduced into the laminator as soon as it is properly pre-heated. Ideally the laminator does not have to wait for the next batch of pre-heated lay-up, meaning that the preheating is started just at the right moment.

Note that more than one, typically four, lay-up may be pre-heated and laminated in one batch.

These together with other objects of the invention, along with the various features of novelty that characterize the invention, are described in more detail below. For a better understanding of the invention, its operating advantages and the objects and advantages of the present invention, reference is made to the accompanying drawings and description of the embodiments of the invention.

### BRIEF DESCRIPTION OF THE DRAWINGS

For a better understanding of the nature of the present invention, reference should be made in the detailed description taken in conjunction with the accompanying drawings in which:
FIG. 1 illustrates a schematic side view of lay-up of a conventional solar module;
FIG. 2 illustrates a schematic top view of a lay-up of a conventional laminated solar module to be laminated showing positions of the cross-connects;
FIG. 3A is a schematic top view of a heating unit for a solar module to be laminated, according to an embodiment of the present invention; FIG. 3B is a schematic side view of the heating unit equipment;
FIG. 4 is a schematic side view of a laminator according to an embodiment of the present invention; and
FIG. 5 is a flow diagram of a process according to an exemplary embodiment of the present invention;

### DETAILED DESCRIPTION OF THE INVENTION

The present invention will be described with reference to exemplary embodiments and the present invention is not limited to a particular system and methods for laminating sandwiched bodies, lay-up, solar module, except as defined in the appended claims. Embodiments of the present invention may be used with a variety of lamination methods and systems. It will be apparent to one skilled in the art that the present invention may be practiced in a variety of ways within the scope of the claims.

As used herein, the indefinite article ("a", "an") denotes the presence of at least one of the referenced item, and the term 'a plurality' denotes the presence of more than one.

The present invention relates to a system, a method and to production equipment for preparing a lay-up comprising several layers for subsequent lamination. The module can be a solar module sometimes described as a PV (photovoltaic) module in the form of a sandwiched body, e.g. a lay-up of a plurality of material layers.

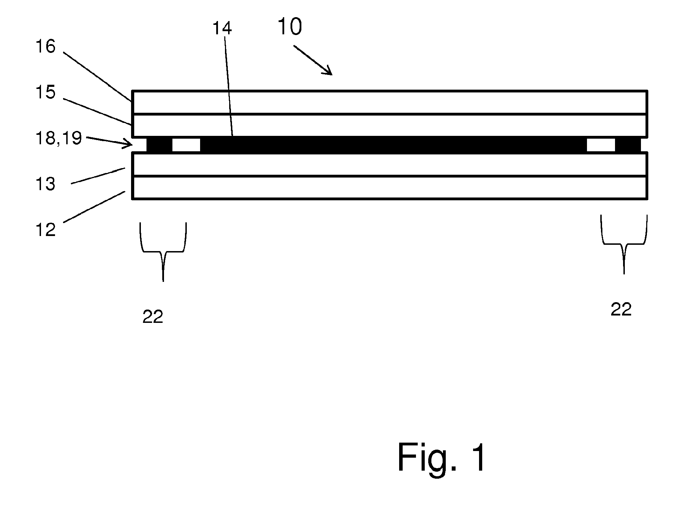

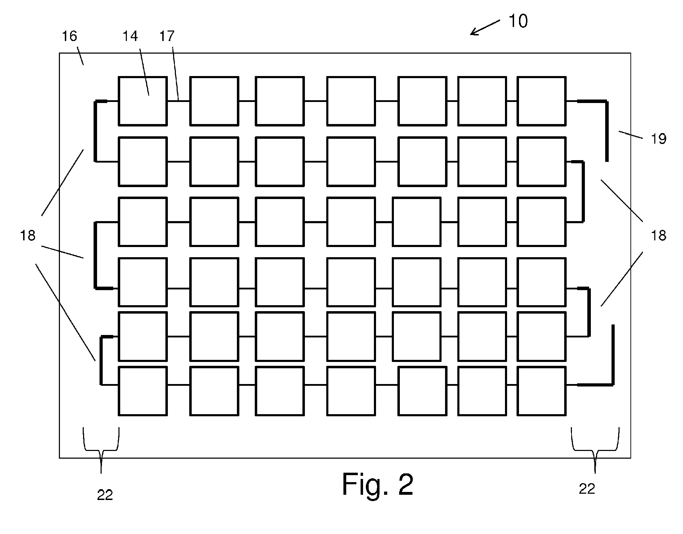

FIGs.1 and 2 illustrate a schematic side and top view, respectively, of a lay-up of a sandwiched body to-be-laminated such as a solar module 10 which is to be used with embodiments of the present invention. In the following reference will be made to a solar module but it should be understood that for all the details described below a sandwiched body is also described and that this body could be for use other than in a solar panel. The solar module 10 has a plurality of material layers including a glass plate 12, normally used to transport the other materials, a first encapsulation layer 13 that can be made of a polymeric material and can be an adhesive foil, a plurality of electronic or electrical components which need to be connected together such as solar cells 14 of any type such as mono-crystalline, polycrystalline, amorphous or thin-film of all sorts, which may also include other electronic components such as switches, diodes, microprocessors, microcontrollers, optical indicators etc., a second encapsulation material 15 e.g. made of a polymeric material and/or in the form of an adhesive foil, and a back sheet 16 that may also be a second glass plate. Once laminated, at least the first encapsulation layer 13 and the glass plate 12 should be transparent (although before the lamination they need not be provided the laminating process renders them transparent). In this embodiment the carrier material is included into the solar panel but re-usable carriers e.g. holding the glass plate, are included within the scope of this invention. With reference to Fig. 2, the electronic components such as solar cells 14 are interconnected by conductive lines 17, wires, strips or ribbons. These conductive lines 17 may be a patterned conductive coating such as a tin oxide coating or they may be one ore more strips of conductive material such as metal or conductive plastic or they can be wires. Solar cells 14 and other electrical components are usually connected in strings in series or in series and parallel for which cross-connectors 18 are required between strings of electronic components such as solar cells 14. For series strings these cross-connectors 18 are usually at the ends of the lay-up of the solar module 10. The back sheet 16 may be a further glass plate or a plastic sheet e.g. containing PVF or PET. The back sheet 16 is the top layer of the lay-up although it is the bottom layer of the finished the solar panel. During the lamination process, an encapsulation and sealing process takes place in which the solar cells 14 are encapsulated between the glass plate 12 and the back sheet 16.

The embodiment above is described with the back sheet on top however the present invention also includes a reverse order of the materials with the glass plate on the top when laying-up and laminating.

The first encapsulating layer 13 and the second encapsulating layer 15 preferably have encapsulating and adhesive properties, i.e. when heated. The encapsulating material may be a material such as EVA or PVB or TPO/polythene or any other thermoplastic or thermosetting foil such as a silicon based foil. The first encapsulating layer 13 can be placed on the carrier, e.g. the glass plate 12 followed by a number of solar cells which are connected in a series by means of cross connections. The encapsulating layers may also become transparent during the lamination.

Intermediate layers with other functions are included within the scope of the present invention.

In Fig. 2 the cross connectors 18 are visible: 3 on the left and 2 on the right. In addition to the two cross connectors 18 on the right that are connecting strings of cells, two cross connectors 19 can be seen on the right leading to the junction box with cable for connecting the panel to a load and optionally a control system when the solar cells are in use. Wherever a conductive strip or ribbon 17 from a string of cells and a cross connector 18 or 19 lay on top of each other the adjacent layers of the lay-up are spaced apart by the thickness of this sandwich. Where a conductive strip or ribbon 17 from a string of cells and a cross connector 18 or 19 lay on top of each other they are usually joined, normally by soldering. The cross connectors 18 or 19 are for example placed at distal ends of the solar module.

The lay-up includes the materials of the sandwiched body such as the solar module 10 assembled together before it is laminated. In a subsequent heating step, once the lay-up has reached a certain temperature, for example, 30 to 90°C or 60-90°C, a pressure may be applied to the lay- up, pressing all layers together. To assist in the lamination process, embodiments of the present invention make use of dedicated localised heating sources such as preheating tubes/heating lamps directed downwards towards module when at the inlet to the laminator, e.g. on a support or an inlet conveyor. Each sandwiched body, e.g. solar module being locally pre-heated before the lamination process.

In any of the embodiments, after preheating a reflective or isolating sheet can be drawn over the module to prevent loss of heat by radiation from the cross-connection regions.

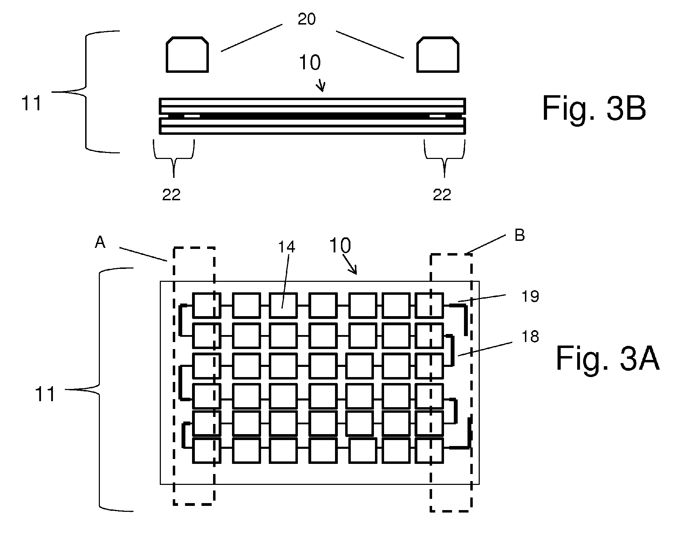

With reference to Figs. 3B and B the dedicated localised heating sources 20 such as heating tubes/heating lamps in the region A and B of a heating unit 11 give the cross connector area 22, where the heat transmission is assumed very low, an advantage in the subsequent lamination process since these regions are already warm after being preheated. In preferred embodiments the heating provided by the dedicated localised heating sources 20 is by radiation. The advantage of this preheating by radiation is that heat may also be transmitted through the transparent back or front sheet such as glass and can then heat surfaces below the glass. Such depths would not be reached quickly by other techniques, e.g. in a circulating oven as then the heat transfer would not be so efficient through the glass which is a thermal insulator. Radiation allows the cross-connectors to be heated quickly despite the fact that the cross-connectors are below the back sheet.

It has been found out that the preheating is much more important in the regions 22 where the cross connectors are. With embodiments of the present invention, costs can be saved as no elaborate large heating plate is needed for the whole module and hence less energy is needed and also time can be saved as heating can be done quicker because energy can be focused and a heat source can be used whose heat energy penetrates the module more easily and quickly.

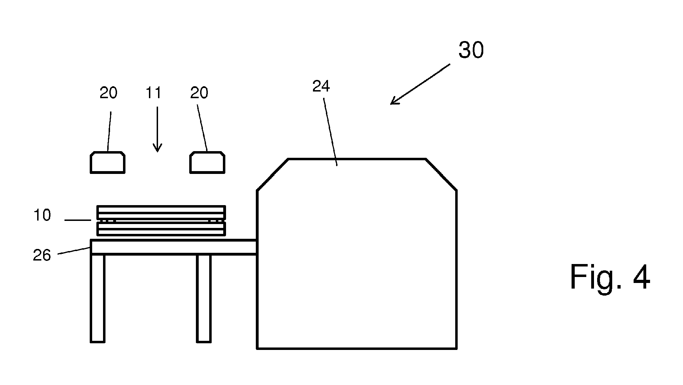

In embodiments of the present invention the preheating before lamination is concentrated in the cross-connection region 22 where the heat propagation is assumed to be the worst during the lamination process. Also peripheral regions may be thus pre-heated depending on the design of the lay-up. Accordingly, as shown in Fig. 4, in front of a laminator 24, the lay-up of a solar module 10 is locally preheated by a dedicated localised heating source 20 such as a heating tube(s) or lamp(s) in a heating unit 11. Such lamps can emit EM radiation such as infrared, near-infrared, light, optionally in the form of a laser, or ultrasound, etc. As energy source LEDs can also be used, or a carbon filament lamp or heating coils etc. The function of these heating sources 20 is to provide local preheating by a dedicated localised heating means whose extent is limited to those areas 22 of the solar module where cross-connectors are placed to thereby reduce the overall amount of heat transferred at this stage while preheating those parts that need to be preheated. In order not to heat a too large region, masks or reflectors may be used. Since the modules produced may be of different size, it is beneficial if the heaters are movably, e.g. by the operator. Means for indicating the distance to the modules (e.g. electronic or an adjustable measurement stick) may be provided to ensure the right amount of energy is applied.

An advantage of using lamps is that they can be switched on quickly and are instantly ready for use. Further they can be equally quickly switched off which allows a fast control of heat energy sent to the laminated object. Thus energy can be saved to a great extent. Also a quick switch off allows a rapid turn-around which can increase throughput.

In one embodiment the preheaters 20 are integrated in the laminator. In another embodiment, the preheaters 20 are the only radiation heaters used in the heating unit 11. In another embodiment the preheaters 20 are the only heaters used in the heating unit 11.

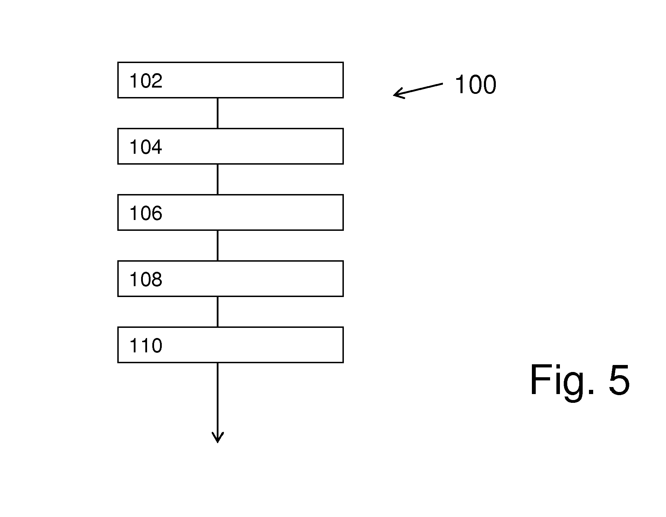

With reference to FIG. 4 a batch laminator system 30 is shown comprising a heating unit 11 which includes a means for preheating the modules and a laminator 24. The heating unit 11 has at least one local preheater 20 for dedicated localised heating of at least one cross-connector region 22 of the solar module 10. Usually there are two dedicated localised heating sources 20 to preheat two cross-connector regions 22. Typically the one or more cross-connector regions 22 are located at the ends of the solar module 10. A flow diagram of a method in accordance with an embodiment of the present invention is shown in Fig. 5. Variations on this method are given below each of which is an embodiment of the present invention:
1. Modules 10 are arranged to wait in front of the laminator 24, for example, when the previous batch is being laminated (see Fig. 4). During this waiting time the modules 10 are partly heated at one or more cross connector areas 22 by the heat source 20, e.g. one or more radiators such as one or more tube lamps.
2. The heat sources 20 such as radiators are installed on top of the support or inlet conveyor 26.
3. The modules 10 are laminated continuously or batchwise in the laminator 24.
4. The dedicated localised heating sources 20 such as heating tubes/heating lamps in the region 2 of the cross connector area may move along with the module 10 as it is conveyed towards the laminator. Thus a means 32 for moving the heat source 20 can be provided.
5. The dedicated localised heating sources 20 such as heating tubes/heating lamps especially radiators in the region 22 of the cross connector area, may alternatively or additionally be located underneath the lay-up (e.g. in the support or conveyor 26).
6. If the lay-up is made in multiple work stations, then the multiple stations may have dedicated localised heating sources 20 such as heating tubes/heating lamps or small heating plates.
7. The dedicated localised heating sources 20 such energy radiating lamps or small heating plates may be integrated in a normal preheating unit which heats up the module 10 generally. In this embodiment the critical areas 22 are heated to a higher temperature and or heated faster than the remainder of the lay-up by means of additional sources 20.
8. The support or conveyor 26 may be thermally insulated in the critical areas to reduce loss and transport (inside the module) of energy and thus allow faster heating.

After preheating, the modules 10 are loaded into the laminator 24. Pressure and heat is applied to the lay-up of the solar module 10 in the laminator. The laminator can include a circulating oven. The laminator 24 may include a vacuum chamber. Materials from the solar module 10 that melt during the lamination process flow to encapsulate the discrete components such as the electronic components. Generally, a plurality of modules 10 are placed on a support or conveyor 26 which may be adapted for moving the lay-ups into the laminator 24 and the laminated solar modules 10 out of the laminator.

According to an exemplary embodiment of the present invention, a suitable receiving means such as a support or conveyor 26 on the heating unit 11 can be used as an assembly point for the materials of the lay-up or a pick-and-place unit may do this automatically. The conveyor 26 may be used to transport the lay-up into the laminator 24. The laminator 24 can comprise two parts: a vacuum chamber for receiving the partly pre-heated lay-ups where the lay-up is heated further and pressure is applied preferably under vacuum. In a second stage the heated and pressed lay-up may be transported to a press where the materials are kept at a high enough temperature to allow for polymerization of the encapsulating materials. In that second or a third stage the laminated may be cooled, preferably under pressure.

In a further embodiment the preheater can be completely or partly integrated into the laminator. When laminating a module in the laminator, the lay-up is introduced into a vacuum chamber. Once the chamber is closed, the air is removed and at the same time the lay-up is heated. In order not to make the lay-up or the produced module form itself into a dish shape, the lay-up at first is kept at a certain distance from the heating means for the actual laminating. After the air has been removed to a satisfactory extent and the lay-up has been warmed-up (especially the glass plate has a more homogenous elevated temperature), the lay-up is applied to the heating means, such as a heating plate. In accordance with this embodiment, before the module touches the heating plate, the critical areas may be pre-heated by a preheater in the vacuum chamber. The preheater may be integrated in the heating plate (heating from below), in the membrane (preheating from above) or in a heating plate that presses on the lay-up during lamination (also preheating from above).

In this embodiment the preheater may be placed in an entrance part of the laminator and the preheating is done as the lay-up enters the laminator, e.g. as it is travelling on an inlet conyeyor. In order to avoid that the all of the module is heated as it passes over and/or under the local preheater, the latter can be switched on and off so as only to locally heat the cross-connector region(s). A controller can be provided adapted to switch the local preheaters at the correct times (see below). When laminating a module in the laminator, the lay-up is introduced into a vacuum chamber as described above.

In accordance with an embodiment of the present invention a control system is provided for control of the dedicated localised heating means such as selected from the group heating tubes, lamps, heating plates, and radiators. The control system has a controller for controlling parameters of the dedicated localised heating means such as the time of switching on and off. The controller can also activate the conveyor 26 to move the module 10 into the laminator. The controller can also control the operation of the dedicated localised heating means and the laminator so as to co-ordinate the operation of the laminator and the heating units to conserve energy in an efficient manner. The controller may be adapted to synchronise the preheating and the operation cycle of the laminator so that preheating is only begun close to the end of the laminator cycle so that unnecessary heating is avoided. The controller may also measure the temperature of the pre-.heated regions, preferably keeping that temperature at the desired level. For this purpose temperature sensors may be located at appropriate positions. The sensors are used to control the system to determine temperature of the cross-connect regions and to pre-heat accordingly, e.g. to a desired temperature. The controller can also be adapted to control on the amount of heat energy transferred, e.g. radiated.

According to an embodiment of the present invention (see FIG. 5), a method 100 for laminating a module, that has been assembled in a heating unit 11, is provided, the method comprising the step of laying up the module 10 in step 102; preheating a lay-up of the module at a step 104, the preheating being a dedicated localised heating in a cross connector region 22 of the module, followed by removing the preheated module from the heating unit in step 108 and introducing the preheated module into a laminator 24 in step 110. In an alternative step 106 the radiation preheaters 20 are switched off before step 108 is carried out.

Although a particular embodiment of the invention has been disclosed in detail for illustrative purposes, it will be recognized to those skilled in the art that variations or modifications of the disclosed invention, including the rearrangement in the configurations of the parts, changes in sizes and dimensions, variances in terms of shape may be possible. Accordingly, the invention is intended to embrace all such alternatives, modifications and variations as may fall within the spirit and scope of the present invention.

The foregoing descriptions of specific embodiments of the present invention have been presented for purposes of illustration and description. They are not intended to be exhaustive or to limit the invention to the precise forms disclosed, and obviously many modifications and variations are possible in light of the above teaching. The embodiments were chosen and described in order to best explain the principles of the invention and its practical application, to thereby enable others skilled in the art to best utilize the invention and various embodiments with various modifications as are suited to the particular use contemplated. It is understood that various omissions, substitutions of equivalents are contemplated as circumstance may suggest or render expedient, but is intended to cover the application or implementation without departing from the spirit or scope of the claims of the present invention.

## Claims

1. Apparatus for preheating a lay-up of a solar cell module, the apparatus comprising:
a preheater for preheating the lay-up of the module, the preheater being a dedicated localised heating means for locally preheating the lay-up

2. The apparatus of claim 1 wherein the dedicated localised heating means is arranged to pre-heat a cross-connector region of the lay-up.

3. The apparatus according to claim 1 or 2 wherein the dedicated localised heating means heats by radiation.

4. The apparatus of claim 1, 2 or 3 wherein the dedicated localised heating means is selected from the group heating tubes, heating coils, lamps, heating plates, radiators.

5. The apparatus of any previous claim wherein the dedicated localised heating means is located above the lay-up and applies heat energy from above, and/or wherein the dedicated localised heating means is located below the lay-up and applies heat energy from below.

6. The apparatus of claim 5 wherein the dedicated localised heating means is located below the lay-up, further comprising a support for supporting or conveying the lay-up and the dedicated localised heating means is located in the support.

7. The apparatus of any previous claim further comprising a laminator for laminating the lay-up.

8. The apparatus according to any previous claim integrated into a laminator.

9. A laminator for laminating lay-ups of solar cell modules, the laminator having at least one vacuum chamber, wherein the preheater for preheating the lay-up of the module is integrated in the at least one vacuum chamber.

10. The laminator of claim 9 wherein the preheater is a dedicated localised heating means for locally preheating the lay-up in a cross-connector region of the lay-up or is an apparatus according to any of the claims 1 to 6.

11. The laminator of claim 9 or 10 wherein the preheater is integrated in a lower heating plate with preheating of the lay-up from below, in a membrane with preheating from above or in an upper heating plate that presses on the lay-up during lamination with preheating from above.

12. A method for laminating lay-up of a solar cell module, the method comprising the steps of:
locally preheating a lay-up of the solar cell module, and laminating the lay-up.

13. The method of claim 12, wherein the preheating is dedicated localised heating in a cross connector region of the module, or
wherein the preheating step is performed by dedicated localised heating means selected from the group heating tubes, heating coils, lamps, heating plates, radiators.

14. The method any of the claims 12 to 13 further comprising synchronizing operation of the preheating step and a laminating step.

15. The method of any of the claims 12 to 14 wherein the preheating locally heats the lay-up top 30 to 90°C.
